# EUROPÄISCHE PATENTANMELDUNG

(11) **EP 2 233 604 A1**
(43) Veröffentlichungstag der Anmeldung: **29.09.2010**
(21) Anmeldenummer: 10157497.8
(22) Anmeldetag: 24.03.2010
(51) Int. Cl.: C23C 14/34, B21B 19/14

(54) **Rohrförmiges Sputtertarget und Verfahren zu seiner Herstellung**

(30) Priorität: 24.03.2009 DE 102009015638
(71) Anmelder: Wieland Dental + Technik GmbH & Co. KG, 75179 Pforzheim (DE)
(72) Erfinder: Bossert, Gerolf, 75328 Schömberg (DE); Burkhardt, Ralf, 75180 Pforzheim (DE)
(74) Vertreter: Patentanwälte Ruff, Wilhelm, Beier, Dauster & Partner

(57) **Zusammenfassung**

Ein rohrförmiges Sputtertarget besteht aus einem umformbaren Metall oder einer umformbaren Legierung, wobei das Metall oder die Legierung eine Korngröße < 200 µm, vorzugsweise ≤ 100 µm, besitzt. Dieses Sputtertarget ist vorzugsweise ausgehend von einem rohrförmigen Element durch Walzen unter Aufweitung des rohrförmigen Elements hergestellt.

## Beschreibung

Die Erfindung betrifft ein rohrförmiges Sputtertarget aus einem umformbaren Metall oder einer umformbaren Legierung sowie ein Verfahren zur Herstellung eines solchen Sputtertargets.

Das sogenannte Sputtern ist ein physikalischer Vorgang, bei dem Atome aus einem Festkörper, dem sogenannten Target, durch Beschuss mit energiereichen Ionen, insbesondere Edelgasionen, herausgelöst werden und in die Gasphase übergehen. Diese Atome können dann wieder gezielt auf einem entsprechenden Substrat abgeschieden werden.

Zum Besputtern großflächiger Substrate, wie zum Beispiel Glas für den Bau- bzw. Architekturbereich, für die Automobilverglasung und für Flachbildschirme sowie Solarzellen, werden großflächige Flachtargets bzw. Planartargets eingesetzt. Diese Targets zeichnen sich allerdings durch eine verhältnismäßig niedrige Materialausbeute von ca. 30 bis 40 % im Sputterprozess aus. Dementsprechend müssen 60 bis 70 % des Materials als Recyclingmaterial wieder zurück in den Kreislauf geführt werden. Außerdem führt der geringe Ausnutzungsgrad bei den sehr teuren Beschichtungsanlagen zu vermehrten Stillstandszeiten.

Deshalb wurden in den letzten Jahren zunehmend auch sogenannte Rohrtargets verwendet, bei denen das entsprechende Material von einem rohrförmigen Körper, der im Einsatz rotiert, abgetragen wird. Solche Rohrtargets ermöglichen Materialausbeuten von bis zu 90 % und machen dementsprechend die Beschichtungsanlagen sehr viel wirtschaftlicher.

Wichtige Materialien, die insbesondere zu den oben genannten Zwecken zu Sputtertargets verarbeitet werden, sind insbesondere reine Metalle wie Silber (Ag), Aluminium (Al), Zink (Zn), Zinn (Sn) und andere sowie Legierungen, insbesondere der vorgenannten Metalle, aber auch von Kupfer (Cu), wie ZnAl, AlSi, CuGa, Culn, CuGaln und andere (mit Ga = Gallium und In = Indium).

Die Herstellung der sogenannten Rohrtargets ist jedoch aufgrund ihrer Dimensionen nicht einfach. So werden solche Rohrtargets in einer Gesamtlänge bis zu (mindestens) 4000 mm benötigt, die aber häufig aus Segmenten von 100 mm bis 1000 mm Länge zusammengesetzt werden. Dieses Zusammensetzen erfolgt in der Regel auf einem Tragrohr, zum Beispiel aus Edelstahl, auf das die Rohrsegmente aufgelötet oder aufgeklebt werden.

Derzeit erfolgt die Herstellung der Rohrtargets bzw. von deren Segmenten nach einer Reihe verschiedener Verfahren.

So werden solche Rohre häufig gegossen, beispielsweise durch Kokillenguss (Blockguss), Strangguss oder Schleuderguss. Dies sind vergleichsweise einfache und kostengünstige Herstellverfahren. Sie besitzen jedoch den Nachteil, dass in der Regel im Material grobe Körner gebildet werden sowie häufig Lunker und Gaseinschlüsse. Dies führt bei Verwendung des entsprechenden Sputtertargets häufig zu nicht akzeptablen Beschichtungsergebnissen, da in die abgeschiedenen Schichten entweder Fehlstellen eingebaut werden oder die Schichtdicke zu stark schwankt.

Hierbei ist zu berücksichtigen, dass mit den genannten Beschichtungsverfahren Schichtdicken bis zu unterhalb 10 nm zuverlässig, d.h. ohne Fehlstellen und ohne relevante Dickenabweichung, hergestellt werden müssen.

Weiter werden Rohrtargets durch das sogenannte Flammspritzverfahren hergestellt. Dies ist ebenfalls ein kostengünstiges Herstellungsverfahren. Allerdings werden auch hier häufig Prozessgase in das Material eingebaut und die erzielte Materialdichte beträgt in der Regel maximal 97 %. Außerdem ist die Teilchengröße/Korngröße schlecht steuerbar und die Materialien neigen zur Grobkörnigkeit.

Es ist auch möglich, Rohrtargets aus Pulver in einem Pressverfahren herzustellen. Hier handelt es sich jedoch um ein vergleichsweise teures Herstellungsverfahren mit hohem Investitionsbedarf. Restporositäten in der Größenordnung von 2 bis 3 % sind hier ebenfalls nicht vermeidbar.

Schließlich sei noch die Möglichkeit der Herstellung von Rohrtargets durch Strangpressen erwähnt. Hier stehen allerdings in der Regel nur Anlagen bis 120 mm Außendurchmesser zur Verfügung. Diese Außendurchmesser liegen unterhalb derjenigen Werte, die für übliche Sputteranlagen mit Rohrtargets nötig sind.

Dementsprechend stellt sich die Erfindung die Aufgabe, zum einen ein neues Verfahren für die Herstellung sogenannter Rohrtargets zur Verfügung zu stellen. Dieses Verfahren soll in einfacher Weise ohne einen großen Anlagenaufwand realisierbar sein. Zum anderen stellt sich die Erfindung die Aufgabe, ein neues Rohrtarget mit verbesserten Materialeigenschaften zur Verfügung zu stellen. Dieses Rohrtarget soll in besonderer Weise in Sputteranlagen für die oben genannten Zwecke einsetzbar sein.

Diese Aufgabe wird gelöst durch das rohrförmige Sputtertarget mit den Merkmalen des Anspruchs 1 und durch das Verfahren mit den Merkmalen des Anspruchs 9. Bevorzugte Ausführungen dieses Sputtertargets und dieses Verfahrens sind in den abhängigen Ansprüchen 2 bis 8 bzw. 10 bis 15 beschrieben. Der Wortlaut sämtlicher Ansprüche wird hiermit durch Bezugnahme zum Inhalt dieser Beschreibung gemacht.

Das erfindungsgemäße rohrförmige Sputtertarget besteht aus einem umformbaren Metall oder einer umformbaren Legierung, wobei dieses Metall oder diese Legierung eine Korngröße < 200 µm besitzt. Vorzugsweise beträgt die Korngröße des Metalls oder der Legierung im erfindungsgemäßen Sputtertarget ≤ 100 µm.

Unter Korngröße soll dabei die durchschnittliche (mittlere) Größe der Kristallite des polykristallinen Materials, hier des entsprechenden Metalls oder der entsprechenden Legierung, verstanden werden.

Das beschriebene erfindungsgemäße Sputtertarget ist vorzugsweise ausgehend von einem rohrförmigen Element hergestellt, wobei dieses rohrförmige Element unter Aufweiten durch einen Walzvorgang zum Sputtertarget verarbeitet ist. Dabei wird in der Regel die Wandstärke/Wanddicke des rohrförmigen Elements beim Walzvorgang reduziert. Die geschilderte Vorgehensweise ist dem Fachmann als sogenanntes Ringwalzen bekannt. Auf die einschlägige Literatur wird hier ausdrücklich Bezug genommen und verwiesen. Entsprechende Verfahren werden beispielsweise auch beim Aufweiten von Trauringen angewandt.

Wie bereits erwähnt kann das erfindungsgemäße Sputtertarget grundsätzlich aus jedem Metall oder jeder Legierung bestehen, die umformbar sind. Unter Umformbarkeit soll dabei die Eigenschaft des Metalls oder der Legierung verstanden werden, durch äußere Beanspruchung bleibend umgeformt/verformt zu werden. Diese plastische Verformung kann dabei, wie im vorliegenden Fall bevorzugt, durch Walzen erfolgen. Das Umformen kann bei Umgebungstemperatur/Raumtemperatur erfolgen, d.h. das entsprechende Material ist "kalt umformbar". Erfolgt die Umformung bei höherer Temperatur spricht man von "warm umformbaren" Materialien, hier Metallen und Legierungen.

Erfindungsgemäß sind für das Sputtertarget alle umformbaren Metalle oder umformbaren Legierungen einsetzbar, die für die entsprechenden Sputteranlagen nachgefragt werden.

Hervorzuheben sind in diesem Zusammenhang als besonders geeignete Materialien
- Edelmetalle und Edelmetalllegierungen, insbesondere Silber und Silberlegierungen,
- Kupfer und Kupferlegierungen,
- Zink und Zinklegierungen,
- Aluminium und Aluminiumlegierungen, und
- Zinn und Zinnlegierungen.

Aus den genannten geeigneten Materialien hervorzuheben sind Kupferlegierungen, wobei es sich hier insbesondere um Kupfer-Gallium (Cu-Ga)-, Kupfer-Indium (Culn)- oder Kupfer-Gallium-Indium (CuGaln)-Legierungen handelt. Der Kupfergehalt der zuletzt genannten drei Legierungen liegt dabei insbesondere zwischen 82 Gew.-% und 98 Gew.-%. Dementsprechend beträgt der Gehalt an Gallium und/oder Indium dieser Kupferlegierungen 2 Gew.-% bis 18 Gew.-%. Handelt es sich um Kupfer-Gallium- oder um Kupfer-Gallium-Indium-Legierungen, so weisen diese galliumhaltigen Legierungen vorzugsweise Galliumgehalte zwischen 5 Gew.-% und 18 Gew.-% auf.

Von den Legierungen ebenfalls besonders hervorzuheben sind Zink-Aluminium-Legierungen, wobei Aluminium in Mengen zwischen 2 Gew.-% und 5 Gew.-% enthalten sein kann, und Aluminium-Silizium-Legierungen.

Die Erfindung ist jedoch ausdrücklich nicht auf die genannten speziellen Legierungen beschränkt.

Die das erfindungsgemäße Sputtertarget bildenden Metalle oder Legierungen besitzen vorzugsweise eine sogenannte Vickers-Härte von maximal 180 HV (geglüht), insbesondere von maximal 150 HV (geglüht). Materialien mit solchen maximalen Härten lassen sich besonders gut durch Walzen in die erfindungsgemäßen rohrförmigen Sputtertargets umformen.

In Weiterbildung ist das erfindungsgemäße Sputtertarget spanend nachbearbeitet. Dies bedeutet, dass auf die eigentliche Herstellung eine solche spanende Nachbearbeitung folgt, beispielsweise um ein Sputtertarget mit exakten Abmessungen und definierten Oberflächen bereitzustellen. Die spanende Nachbearbeitung erfolgt dabei vorzugsweise durch Drehen (d.h. auf einer Drehbank oder Drehmaschine).

Die durch die Nachbearbeitung bereitgestellten exakten Abmessungen und Oberflächen sind beispielsweise für das Aufbringen der Sputtertargets auf die eingangs erwähnten Tragrohre und für einen definierten Abtrag der Metallatome aus dem Target beim Sputtervorgang von Vorteil.

Das Sputtertarget kann grundsätzlich mit allen Abmessungen bereitgestellt werden, die für Sputteranlagen mit rohrförmigen Targets gefordert werden.

Vorzugsweise weist das erfindungsgemäße Sputtertarget eine Länge ≤ 800 mm, insbesondere ≤ 400 mm, auf. Dies sind diejenigen Längen, die üblicherweise für rohrförmige Segmente von Sputtertargets zum Einsatz kommen.

Insbesondere weist das erfindungsgemäße Sputtertarget, in der Regel nach der Nachbearbeitung, einen Außendurchmesser ≤ 200 mm, vorzugsweise ≤ 150 mm, auf. Auch diese Außendurchmesser entsprechen den üblichen Abmessungen entsprechender Rohrtargets oder Rohrtarget-Segmente.

In entsprechender Weise sind für die erfindungsgemäßen Sputtertargets Innendurchmesser von ≤ 150 mm, vorzugsweise ≤ 130 mm, bevorzugt. Auch hier handelt es sich in der Regel um die Abmessungen nach der erwähnten Nachbearbeitung.

Die Wandstärke (Wanddicke) der erfindungsgemäßen Sputtertargets beträgt vorzugsweise ≥ 10 mm, insbesondere ≥ 25 mm. Auch diese Maße sind bei den derzeit eingesetzten rohrförmigen Sputtertargets bzw. den entsprechenden Segmenten für solche Sputtertarges üblich.

Neben dem erfindungsgemäßen Sputtertarget umfasst die Erfindung auch ein Verfahren zur Herstellung eines rohrförmigen Sputtertargets, insbesondere zur Herstellung der erfindungsgemäßen rohrförmigen Sputtertargets.

Dieses erfindungsgemäße Verfahren ist **dadurch gekennzeichnet, dass** ein rohrförmiges Element aus einem umformbaren Metall oder einer umformbaren Legierung unter Aufweitung seines Außendurchmessers bei gleichzeitiger Reduzierung der Wandstärke (Wanddicke) zu einem rohrförmigen Sputtertarget gewalzt wird. Dieser Walzvorgang ist als sogenanntes Ringwalzen bekannt.

Zum Begriff des Ringwalzens und zu den anderen Begriffen, die bei der Beschreibung des erfindungsgemäßen Verfahrens verwendet werden, wird ausdrücklich auf die bisherigen Ausführungen Bezug genommen und verwiesen.

Insbesondere erfolgt bei dem erfindungsgemäßen Verfahren eine Reduzierung der Wandstärke um den Faktor 2 bis 3, d.h. die Wandstärke des rohrförmigen Elements, aus dem das rohrförmige Sputtertarget durch Walzen gefertigt wird, ist um den Faktor 2 bis 3 größer als die Wandstärke des fertigen rohrförmigen Sputtertargets, insbesondere auch nach einer möglichen spanenden Nachbearbeitung dieses Sputtertargets.

In Weiterbildung ist es bevorzugt, wenn bei dem erfindungsgemäßen Verfahren beim Walzvorgang mindestens zwei (aufeinanderfolgende) Walzschritte vorgesehen sind. Damit lässt sich der Ablauf des Gesamtverfahrens besser kontrollieren, beispielsweise durch eine Kontrolle der Abmessungen des Sputtertargets und damit des Fortschritts des Verfahrens.

Weiter ist es bei dem erfindungsgemäßen Verfahren bevorzugt, wenn mindestens ein Walzschritt, insbesondere alle Walzschritte, bei erhöhter Temperatur erfolgen. Dementsprechend handelt es sich bei den entsprechenden Walzschritten um Verfahrensschritte, bei denen eine Warmumformung erfolgt.

Grundsätzlich kann die erhöhte (Walz-)Temperatur frei gewählt werden. Bevorzugt ist, wenn die Walztemperatur bis zu 50 %, vorzugsweise ungefähr 50 %, der Schmelztemperatur des umformbaren Metalls oder der umformbaren Legierung beträgt.

In Weiterbildung ist es bei dem erfindungsgemäßen Verfahren bevorzugt, wenn nach mindestens einem Walzschritt, vorzugsweise nach jedem Walzschritt, eine Wärmebehandlung zur Rekristallisation des umformbaren Metalls oder der umformbaren Legierung erfolgt. Solche Wärmebehandlungen sind dem Fachmann bekannt. Sie dienen dazu, Fehlstellen im Material durch die entsprechende Wärmebehandlung "auszuheilen".

Auch die Temperatur der Wärmebehandlung ist grundsätzlich frei wählbar. Sie beträgt vorzugsweise zwischen ca. 50 % und ca. 75 % der Schmelztemperatur des umformbaren Metalls oder der umformbaren Legierung.

In Weiterbildung wird das rohrförmige Sputtertarget nach Abschluss der Walzschritte spanend nachbearbeitet, vorzugsweise durch Drehen auf einer Drehbank oder Drehmaschine. Dabei werden, wie bereits erläutert, die Abmessungen des rohrförmigen Sputtertargets endgültig festgelegt und die entsprechenden Oberflächen definiert.

Aufgrund der Tatsache, dass das erfindungsgemäße Verfahren eine (in der Regel sehr präzise) Walzbearbeitung beinhaltet, sind bei der Erfindung die zur Einstellung (Kalibrierung) der Innen- und Außendurchmesser durch die Nachbearbeitung abzutragenden Materialmengen, vergleichsweise gering. Dies macht das erfindungsgemäße Verfahren insbesondere bei teuren Metallen und Metalllegierungen aufgrund der geringen Materialverluste besonders vorteilhaft.

Das rohrförmige Element, aus dem das Sputtertarget durch Walzen gefertigt wird, kann grundsätzlich auf jede beliebige Weise hergestellt sein.

Hierzu wird auf die einleitenden Ausführungen in der Beschreibung Bezug genommen. Vorzugsweise wird dieses rohrförmige Element durch ein Gussverfahren hergestellt, wobei in das Gussteil anschließend eine Mittelbohrung (axiale Bohrung) eingebracht wird.

Durch das erfindungsgemäße Sputtertarget und durch das erfindungsgemäße Verfahren werden eine ganze Reihe von Vorteilen bereitgestellt.

So kann für Sputtervorgänge ein feinkörniges Material mit einer Materialdichte von ca. 100 % zur Verfügung gestellt werden und dies durch ein vergleichsweise kostengünstiges Verfahren. Dies äußert sich zum einen in den vergleichsweise geringen Investitionskosten und zum anderen in den vergleichsweise niedrigen Herstellungskosten für das im Verfahren verwendete rohrförmige Element. Das Verfahren ist aufgrund der vergleichsweise einfachen Anlage, auf der es betrieben wird, gut beherrschbar.

Weiter hervorzuheben ist, dass nur sehr geringe Verunreinigungen an Fremdmetallen oder Gasen im Material vorliegen und dass das eingesetzte Ausgangsmaterial mit üblichen kostengünstigen Methoden in hoher Reinheit produziert werden kann.

Der im Verfahren eingesetzte Walzvorgang führt zu einer Verdichtung und Verfeinerung des Gefüges, was sich an den Korngrößen von weniger als 200 µm, insbesondere ≤ 100 µm zeigt.

Die geschilderten und weiteren Merkmale der Erfindung ergeben sich aus der nachfolgenden Beschreibung der Beispiele in Verbindung mit den Zeichnungen und den Unteransprüchen. Dabei können die einzelnen Merkmale für sich allein oder in Kombination miteinander verwirklicht sein.

In den Zeichnungen zeigen
- Fig. 1: die schematische Darstellung einer Vorrichtung, mit deren Hilfe das erfindungsgemäße Verfahren durchführbar und das erfindungsgemäße Sputtertarget herstellbar ist (Fig. 1A: Schnittansicht in Längsrichtung; Fig. 1B: Schnittansicht in Querrichtung),
- Fig. 2: Gefügebild eines erfindungsgemäßen Sputtertargets aus Silber in 50-facher Vergrößerung,
- Fig. 3: Gefügebild eines erfindungsgemäßen Sputtertargets aus Silber in 1 00-facher Vergrößerung,
- Fig. 4: Gefügebild eines stranggegossenen rohrförmigen Sputter- targets aus Silber (Stand der Technik) in 50-facher Vergrö- ßerung,
- Fig. 5: Gefügebild eines stranggegossenen rohrförmigen Sputter- targets aus Silber (Stand der Technik) in 100-facher Vergrö- ßerung,
- Fig. 6: Gefügebild eines im Blockguß hergestellten, rohrförmigen Sputtertargets aus Silber (Stand der Technik) in 50-facher Vergrößerung, und
- Fig. 7: Gefügebild eines im Blockguß hergestellten, rohrförmigen Sputtertargets aus Silber (Stand der Technik) in 100-facher Vergrößerung.

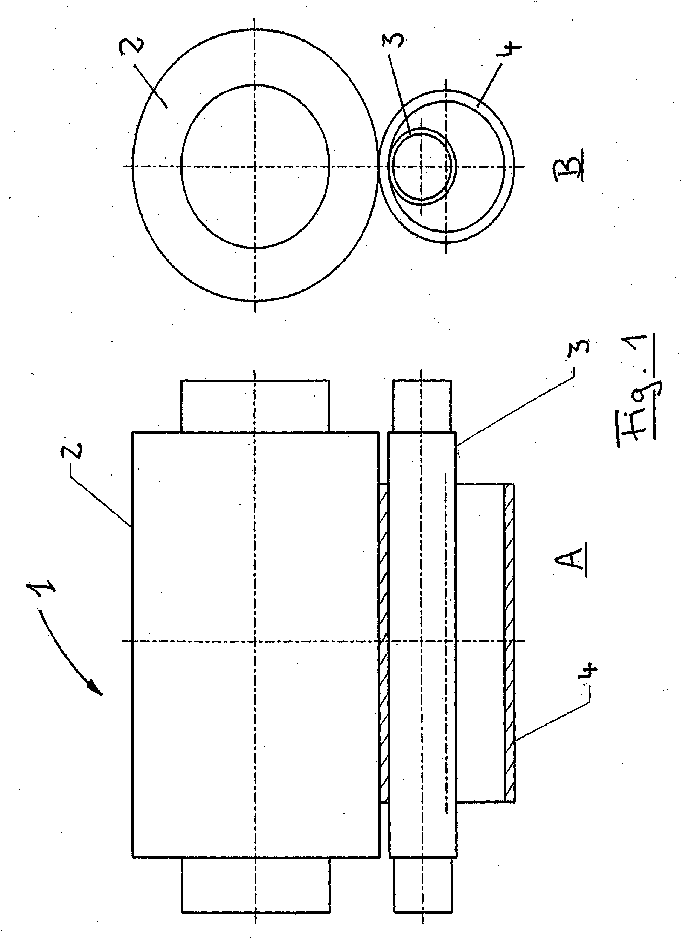

Fig. 1 zeigt schematisch die Vorrichtung 1 (Walzanlage), mit deren Hilfe das erfindungsgemäße Verfahren durchführbar und die erfindungsgemäßen Sputtertargets herstellbar sind.

Die Vorrichtung 1 besitzt Walzenständer mit einer lichten Weite von 400 mm, die in Fig. 1 nicht dargestellt sind. Mit Hilfe der Vorrichtung 1 kann eine Antriebsleistung von 35 KW bereitgestellt werden und ein Walzdruck von 200 t. Die Vorrichtung 1 besitzt ein Kammantriebsgetriebe mit zwei Abtriebswellen und eine seitliche Lagersitzöffnung von 300 mm.

Die eigentliche Walzarbeit wird von der in der Fig. 1 dargestellten Walzenrolle 2 und der gehärteten und ebenfalls angetriebenen Steckachse (Dornstange) 3 geleistet. Die Walzenrolle 2 besitzt einen Durchmesser von 250 mm und eine Länge von 350 mm. Die Steckachse 3 besitzt einen Durchmesser von 60 mm und eine Länge von 700 mm.

Zwischen Walzenrolle 2 und Dornstange 3 wird das rohrförmige Element 4 angeordnet und zum rohrförmigen Sputtertarget gewalzt. Dieses Walzen des rohrförmigen Elements 4 zwischen Walzenrolle 2 und Dornstange 3 ist in Fig. 1 dargestellt. Dabei erfolgt die Wanddickenreduzierung und die Durchmesseraufweitung des rohrförmigen Elements 4 über das gezielte Zustellen der Walzenrolle 2 gegen die doppelt gelagerte Steckachse 3.

Fig. 1A zeigt die Vorrichtung 1 in einer schematischen Schnittdarstellung in Längsrichtung. Fig. 1B zeigt die Vorrichtung 1 in schematischer Schnittdarstellung in Querrichtung.

Mit Hilfe der Vorrichtung 1 gemäß Fig. 1 werden die im folgenden erläuterten Beispiele durchgeführt.

### Beispiel 1

Zur Herstellung eines rohrförmigen Sputtertargets (Segment eines Sputtertargets) aus Silber wird zunächst ein Feinsilberbolzen von 120 mm Außendurchmesser und 270 mm Länge im Vakuumblockguss-Verfahren gegossen. Feinsilber ist bekanntlich die Bezeichnung für chemisch reines Silber (1000/1000 Silber).

In diesen Feinsilberbolzen wird eine Mittelbohrung mit Durchmesser 61 mm eingebracht. Der Block wird auf 500 °C erwärmt und auf der Vorrichtung 1 nach dem erfindungsgemäßen Verfahren ausgewalzt. Nach dem Auswalzen betrug der Außendurchmesser 165 mm und der Innendurchmesser 128 mm. Anschließend wird das Sputtertarget auf einer Drehbank auf Fertigmaß gedreht (spanend nachbearbeitet). Anschließend betrugen die Abmessungen 160 mm (Außendurchmesser) x 130 mm (Innendurchmesser) x 250 mm (Länge). An dem zur Längeneinstellung abgetrennten Kopfstück wird die Korngröße des Silbers im erfindungsgemäßen Sputtertarget bestimmt.

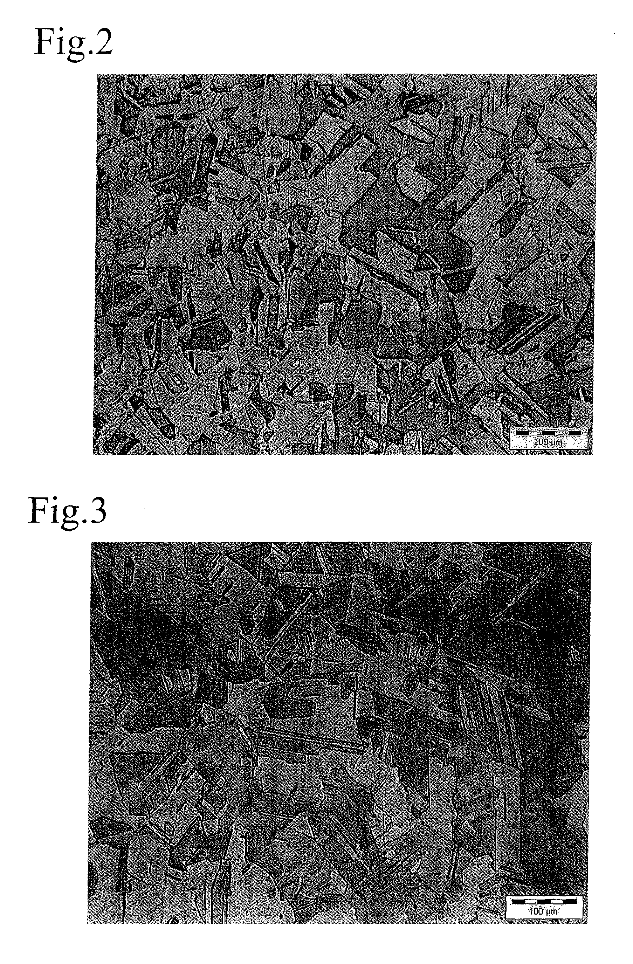

Die Korngrößen im erfindungsgemäßen Sputtertarget sind in den Gefügebildern gemäß Fig. 2 und 3 bei unterschiedlichen Vergrößerungen dargestellt. So zeigt Fig. 2 das Gefüge des erfindungsgemäßen Sputtertargets aus Feinsilber in 50-facher Vergrößerung mit dem eingezeichneten Maßstab von 200 µm. Analog ist in Fig. 3 das Gefüge des erfindungsgemäßen Sputtertargets aus Feinsilber in 100-facher Vergrößerung mit eingezeichnetem Maßstab von 100 µm dargestellt.

Es ist ohne weiteres zu erkennen, dass die mittlere Korngröße des erfindungsgemäßen Sputtertargets aus Silber weniger als 200 µm beträgt. Detailliertere Analysen zeigen mittlere Korngrößen zwischen 100 µm und 200 µm in solchen Sputtertargets.

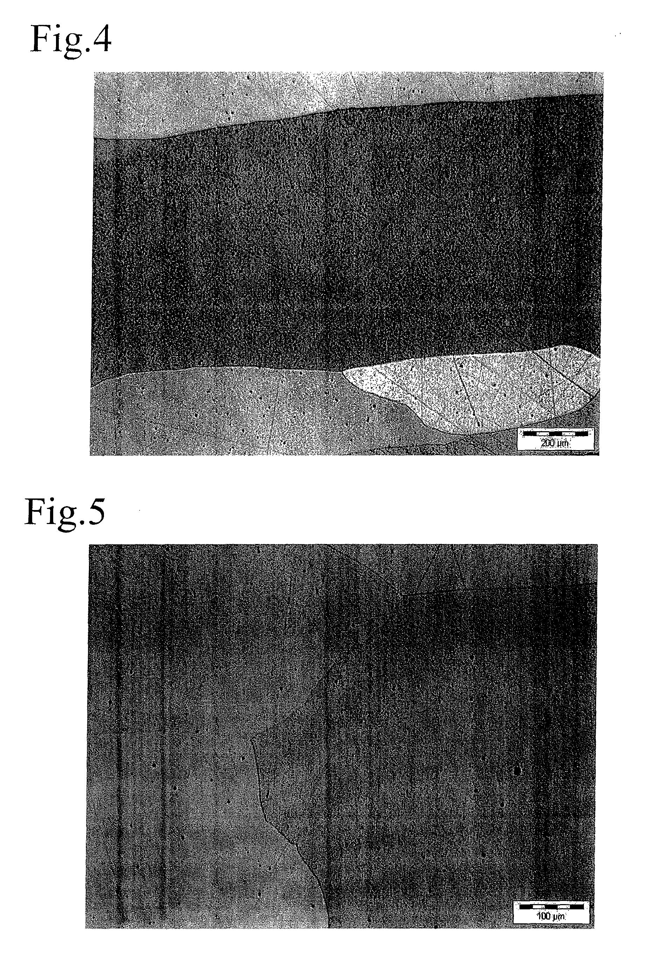

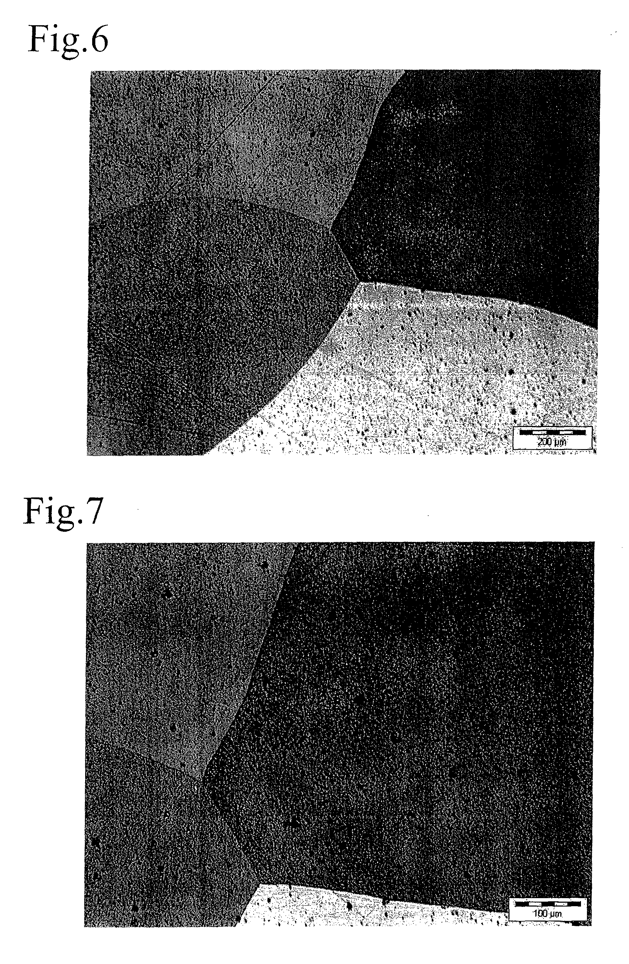

Zum Vergleich wird im Zusammenhang mit Beispiel 1 auf die Fig. 4 bis 7 verwiesen. In diesen Figuren sind Gefügebilder von Sputtertargets aus Feinsilber dargestellt, die nach einem Strangguss-Verfahren bzw. Blockguss-Verfahren hergestellt sind. Die Fig. 4 und 5 zeigen dabei die Gefügebilder des Strangguss-Sputtertargets aus Feinsilber bei 50-facher bzw. 100-facher Vergrößerung. Die Fig. 6 und 7 zeigen die Blockguss-Sputtertargets aus Feinsilber in 50-facher bzw. 100-facher Vergrößerung. Insgesamt ist zu erkennen, dass die Korngrößen des Strangguss-Sputtertargets und des Blockguss-Sputtertargets weit oberhalb von 200 µm liegen, in der Regel sogar im mm-Bereich. Dies zeigt, dass durch das erfindungsgemäß angewendete Walzverfahren eine Verdichtung und Verfeinerung des Gefüges eintritt und wesentlich kleinere Körner bereitgestellt werden können. Dies verbessert die Verwendbarkeit der erfindungsgemäßen Sputtertargets in den Sputterverfahren, da dort zum Erreichen der fehlerfreien Beschichtungen sehr geringer Schichtdicke (≤ 10 nm) geringere Ausgangskorngrößen im Sputtertarget erwünscht sind.

### Beispiel 2

In entsprechender Weise zu Beispiel 1 wird zunächst in einem Strangguss-Verfahren ein Rohr aus einer ZnAl-Legierung (mit 2 % Al) gegossen. Die Maße dieses Rohrs betrugen 110 mm (Außendurchmesser) x 60 mm (Innendurchmesser) x 150 mm (Länge).

Das so erhaltene Rohr (rohrförmiges Element) wird in einem Luftumwälzofen auf 250 °C erwärmt und dieses vorgewärmte Element nach dem erfindungsgemäßen Verfahren auf die Maße 155 mm (Außendurchmesser) x 125 mm (Innendurchmesser) x 260 mm (Länge) gewalzt. Das so erhaltene erfindungsgemäße Sputtertarget wird durch Drehen kalibriert auf ein Rohrsegment mit 150 mm (Außendurchmesser) x 130 mm (Innendurchmesser) x 250 mm (Länge).

Auch dieses rohrförmige Sputtertarget wies mittlere Korngrößen im beanspruchten Bereich unterhalb 200 µm auf.

### Beispiel 3

Auch hier wurde entsprechend Beispiel 1 zunächst ein Bolzen aus Reinzinn im Blockguss-Verfahren erzeugt (130 mm (Außendurchmesser) x 220 mm (Länge)). Dann wird eine Mittelbohrung mit einem Durchmesser von 65 mm eingebracht und das so vorbereitete Rohr nach dem erfindungsgemäßen Verfahren bei Raumtemperatur ausgewalzt.

Auch hier liegt die mittlere Korngröße des erhaltenen erfindungsgemäßen Sputtertargets aus Zinn im beanspruchten Bereich von < 200 µm.

## Patentansprüche

1. Rohrförmiges Sputtertarget aus einem umformbaren Metall oder einer umformbaren Legierung, **dadurch gekennzeichnet, dass** das Metall oder die Legierung eine Korngröße < 200 µm, vorzugsweise eine Korngröße ≤ 100 µm besitzt.

2. Sputtertarget nach Anspruch 1, **dadurch gekennzeichnet, dass** das Sputtertarget, ausgehend von einem rohrförmigen Element (4), durch Walzen unter Aufweitung des rohrförmigen Elements (4) hergestellt ist.

3. Sputtertarget nach Anspruch 1 oder Anspruch 2, **dadurch gekennzeichnet, dass** es sich bei dem Metall oder der Legierung um ein Edelmetall oder eine Edelmetalllegierung, vorzugsweise um Silber oder eine Silberlegierung, handelt.

4. Sputtertarget nach Anspruch 1 oder Anspruch 2, **dadurch gekennzeichnet, dass** es sich bei dem Metall oder der Legierung um Zink oder eine Zinklegierung, um Aluminium oder eine Aluminiumlegierung oder um Zinn oder eine Zinnlegierung handelt.

5. Sputtertarget nach Anspruch 1 oder Anspruch 2, **dadurch gekennzeichnet, dass** es sich bei dem Metall oder der Legierung um Kupfer oder um eine Kupferlegierung handelt.

6. Sputtertarget nach Anspruch 5, **dadurch gekennzeichnet, dass** es sich bei der Kupferlegierung um eine Kupfer-Gallium-, eine Kupfer-Indium- oder eine Kupfer-Gallium-Indium-Legierung handelt, wobei vorzugsweise der Kupfergehalt dieser Legierungen zwischen 82 Gew.-% und 98 Gew.-% beträgt.

7. Sputtertarget nach einem der vorhergehenden Ansprüche, **dadurch gekennzeichnet, dass** das Sputtertarget spanend nachbearbeitet ist, vorzugsweise durch Drehen.

8. Sputtertarget nach einem der vorhergehenden Ansprüche, **dadurch gekennzeichnet, dass** das Sputtertarget eine Länge ≤ 800 mm, vorzugsweise ≤ 400 mm, einen Außendurchmesser ≤ 200 mm, vorzugsweise ≤ 150 mm, einen Innendurchmesser ≤ 150 mm, vorzugsweise ≤ 130 mm und/oder eine Wandstärke ≥ 10 mm, vorzugsweise ≥ 25 mm, aufweist.

9. Verfahren zur Herstellung eines rohrförmigen Sputtertargets, insbesondere zur Herstellung eines rohrförmigen Sputtertargets nach einem der vorhergehenden Ansprüche, **dadurch gekennzeichnet, dass** ein rohrförmiges Element (4) aus einem umformbaren Metall oder einer umformbaren Legierung unter Aufweitung seines Außendurchmessers bei gleichzeitiger Reduzierung der Wandstärke zu einem rohrförmigen Sputtertarget gewalzt wird.

10. Verfahren nach Anspruch 9, **dadurch gekennzeichnet, dass** das Walzen in mindestens zwei Walzschritten erfolgt.

11. Verfahren nach Anspruch 9 oder Anspruch 10, **dadurch gekennzeichet, dass** mindestens ein Walzschritt bei erhöhter Temperatur erfolgt, wobei vorzugsweise die Walztemperatur bis zu 50 %, insbesondere ungefähr 50 %, der Schmelztemperatur des umformbaren Metalls oder der umformbaren Legierung beträgt.

12. Verfahren nach einem der Ansprüche 9 bis 11, **dadurch gekennzeichnet, dass** nach mindestens einem Walzschritt, vorzugsweise nach jedem Walzschritt, eine Wärmebehandlung zur Rekristallisation des umformbaren Metalls oder der umformbaren Legierung stattfindet.

13. Verfahren nach Anspruch 12, **dadurch gekennzeichnet, dass** die Temperatur der Wärmebehandlung zwischen ca. 50 % und ca. 75 % der Schmelztemperatur des umformbaren Metalls oder der umformbaren Legierung beträgt.

14. Verfahren nach einem der Ansprüche 9 bis 13, **dadurch gekennzeichnet, dass** das rohrförmige Sputtertarget spanend nachbearbeitet wird, vorzugsweise durch Drehen.

15. Verfahren nach einem der Ansprüche 9 bis 14, **dadurch gekennzeichnet, dass** das rohrförmige Element (4), aus dem das Sputtertarget durch Walzen gefertigt ist, durch ein Gussverfahren mit anschließendem Einbringen einer Mittelbohrung in das Gussteil hergestellt ist.
